# EUROPÄISCHE PATENTSCHRIFT

(11) **EP 0 550 802 B1**
(45) Veröffentlichungstag und Bekanntmachung des Hinweises auf die Patenterteilung: **13.08.1997**
(21) Anmeldenummer: 92117679.8
(22) Anmeldetag: 16.10.1992
(51) Int. Cl.: H03B 5/12

(54) **Rauscharmer Oszillator**
Low noise oscillator
Oscillateur à faible bruit

(30) Priorität: 08.01.1992 DE 4200234
(43) Veröffentlichungstag der Anmeldung: 14.07.1993
(73) Patentinhaber: ROBERT BOSCH GMBH, 70442 Stuttgart (DE)
(72) Erfinder: Festag, Winfried, Dipl.-Ing., W-1000 Berlin 41 (DE)

(56) Entgegenhaltungen:
- DE-A- 2 721 406
- US-A- 4 785 264
- RADIO COMMUNICATION Bd. 52, Nr. 5, Mai 1976, LONDON,GB Seiten 359 - 360 . 'The goral oscillator'
- ELECTRONICS & WIRELESS WORLD Bd. 93, Nr. 1617, Juli 1987, SURREY GB Seiten 707 - 709 A. DEKKER: 'Universal voltage-controlled oscillator with low phase noise.

## Beschreibung

Die Erfindung betrifft einen rauscharmen Oszillator, der insbesondere für professionelle portable Geräte der Kommunikationstechnik geeignet ist.

Beispiele für rauscharme Oszillatoren sind aus US-A-4 785 264 und DE-A-2 721 406 bekannt.

Das Anwendungsgebiet reicht von niedrigen Frequenzen bis in das UHF-Gebiet.
Zur Realisierung der Oszillatoren sind eine Vielzahl von Schaltungen bekannt, z.B. die Colpitts- oder die Hartley-Schaltung. Nachteilig sind hierbei die Aufteilung der Schwingkreiskapazität zur Rückkopplung bzw. die Anzapfung der Schwingkreisinduktivität zur Realisierung der Phasenbedingung.

Der Erfindung liegt die Aufgabe zugrunde, eine einfache und universelle Schaltung anzugeben, die auch bei niedrigen Frequenzen ohne die Aufteilung der Schwingkreiskapazität oder die Anzapfung der Schwingkreisinduktivität auskommt.

Diese Aufgabe wird dadurch gelöst, daß die erfindungsgemäße Schaltung wie im kennzeichnenden Teil des Anspruchs 1 dargelegt, aufgebaut ist.

Die erfindungsgemäße Schaltung stellt einen mitgekoppelten Verstärker dar; aufgrund des hohen Eingangswiderstandes des JFET genügt die interne Gate-Source-Kapazität zur Rückkopplung, zumindestens im VHF- und UHF-Gebiet. Die Phasenbedingung wird mit dem Kondensator C3 erfüllt, der gleichzeitig zur Auskopplung der HF-Leistung, die typischerweise zwischen -10 und 0 dbm liegt, dient. Der Scheinwiderstand von C3 muß für sicheres Schwingen bei einer Auskopplung an 50Ω in der Größenordnung des Widerstandes R2 liegen, für den ein typischer Wert 470Ω ist. Für Frequenzen unterhalb 100 MHz sollte der Kondensator C4 hinzugefügt werden, da sonst die Ausgangsleistung merklich absinkt, bei gleichzeitiger Erhöhung der Stromaufnahme, die sonst im Mittel bei 1 mA liegt.
Da der Schwingkreis selbst bei großen Kapazitätswerten des Kondensators C2 relativ wenig "Leitwert sieht", ist die belastete Güte des Kreises, besonders bei kleinem Wert von C2, entsprechend hoch, was sich in besonders geringem Phasenrauschen äußert. Durch die ebenfalls geringe Parallelkapazität läßt sich der Oszillator außerdem in entsprechend größerem Bereich kapazitiv durchstimmen, bzw. kann für einen vorgegebenen VCO-Abstimmbereich die Ankopplung der Kapazitätsdiode entsprechend lose erfolgen, was für das Phasenrauschverhalten der gesamten Schaltung von ausschlaggebender Bedeutung ist.

Besonders wichtige Aufgaben haben die beiden Schottky-Dioden D1,D1' zu erfüllen. Besonders bei niedrigeren Frequenzen kann D1' auch entfallen.

Bei hohen Frequenzen sollten Typen mit kleiner Sperrschichtkapazität gewählt werden. Da diese dann aber oft nur 4 V Sperrspannung vertragen, ist eine Aufteilung des Widerstands R1 zur gleichmäßigeren Verteilung der letzteren sinnvoll. Diese Diodenklemmschaltung begrenzt zum einen die positiven Schwingamplituden und damit die Änderungen der JFET-Sperrschichtkapazität, d.h. die Oberwellen generierende Varaktor-Aktion, was sich günstig auf die Stabilität des Oszillators und das Rauschverhalten auswirkt und in entsprechend großem Oberwellenabstand äußert, zum anderen erzeugt und stabilisiert sie die negative Gatevorspannung, wodurch der geringe Stromverbrauch der Schaltung überhaupt erst möglich wird. Außerdem wirkt sie ausgleichend auf die erheblichen Exemplarstreuungen der JFET-Parameter, so daß auch mit Extremwerten eines Typs die Ausgangsleistung höchstens um +/- 2 dB schwankt.

Die Ausgangsleistung des erfindungsgemäßen Oszillators läßt sich in weitem Bereich durch entsprechende Dimensionierung des Widerstands R2 und des Kondensators C3 einstellen. Die Induktivität L2 wirkt als reine Sperrdrossel für den jeweiligen Frequenzbereich.
Mit der Bemessung von C2 (und auch ggf. mit C4) wird ein Kompromiß zwischen Stromverbrauch und Phasenrauschen getroffen, bei hoher Schwingkreisgüte kann sowohl eine sehr geringe Stromaufnahme als auch ein äußerst geringes Phasenrauschen realisiert werden.

Die Stromaufnahme ist außerdem praktisch unabhängig von der gewählten Betriebsspannung, ein typischer Wert für letztere ist 5 V.

Der erfindungsgemäße VCO zeichnet sich durch geringes Phasenrauschen, geringe Stromaufnahme, Einfachheit der Schaltung und Universalität aus. Die Verwendung preiswerter Standardbauteile ist möglich. Die vorgeschlagene Schaltung erfüllt damit in hervorragender Weise die Forderungen, die heute an professionelle portable Geräte der Kommunikationstechnik gestellt werden.
Nachfolgend sollen Ausführungsbeispiele der Erfindung anhand der Zeichnung näher erläutert werden.
Es zeigt
- Fig. 1: das Schaltbild des erfindungsgemäßen Oszillators
- Fig. 2: ein Beispiel für den 70 cm-Bereich als VCO
- Fig. 3: die Einordnung der erfindungsgemäßen Schaltung in Sender und Empfänger im 2 m-Bereich als VCO's
- Fig. 4: die Ausgestaltung der erfindungsgemäßen Schaltung als temperaturkompensierten Quarzoszillator (TCXO)
- Fig. 5: Typische Temperaturabhängigkeit des TCXO

In allen Ausführungsbeispielen wird als JFET der Hochstromtyp J 310 eingesetzt.

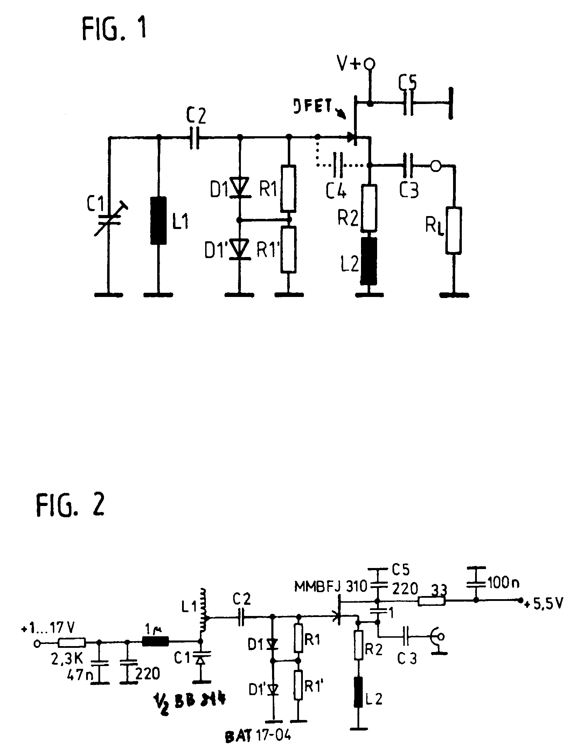

In Fig. 2 haben die Bauteile der erfindungsgemäßen Schaltung folgende Grobdimensionierung:
L1-Helixkreis Neosid 7 mm mit 7 Windungen und Anzapfung bei 2,5 Windungen,
C1-Typ BB 814/2,
C2 = 4,7 pF, C3 = 0,5 pF, C5 = 220 pF
D1, D1'-Typ BAT 17-04
R1, R1'= 470kΩ, R2 = 68Ω, L2 = 270 nH.

Innerhalb des Abstimmbereiches von kleiner 440 MHz bis größer 480 MHz ( Δf > 40 MHz) ergeben sich bei einer Stromaufnahme von 2 - 3 mA eine Ausgangsleistung von -7 bis -4 dBm an 50Ω und ein Phasenrauschen kleiner als 120 dBc in 1 Hz in Δf=20 kHz.

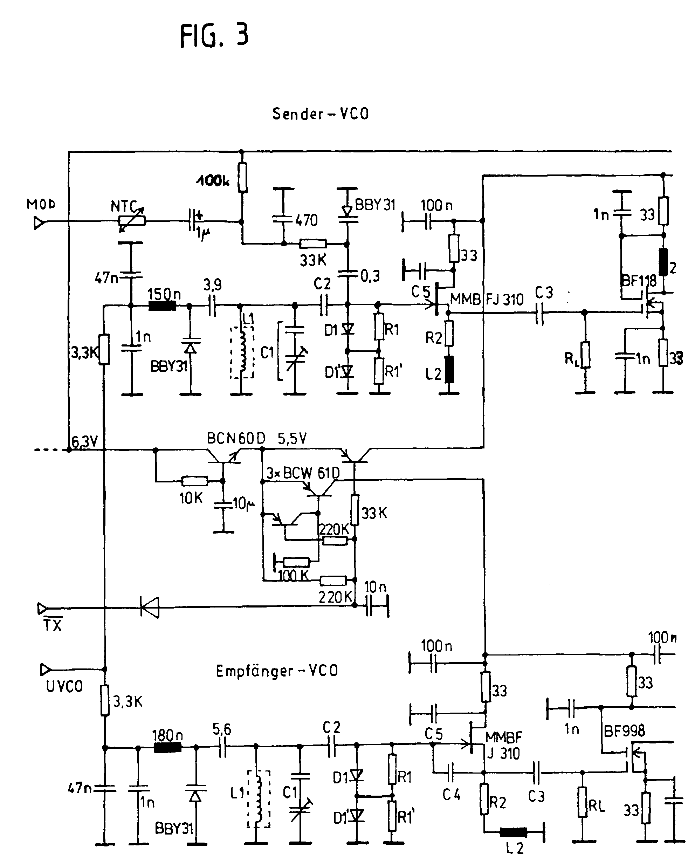

Der in Fig. 3 gezeigte Sender/Empfänger-VCO hat für den Sender eine typische Stromaufnahme von 1 mA, für den Empfänger von 0,7 mA. Das Phasenrauschen ist in beiden Fällen kleiner oder gleich 130 dBc in 1 Hz in Δf = 20 kHz.

Im Sender-VCO haben die Bauteile der erfindungsgemäßen Schaltung folgende Dimensionierung: C1 = 4,7 pF + einstellbar 1 - 3 pF, C2 = 5,6 pF, C3 = 1,8 pF, C5 = 470 pF, D1, D1'-Typ BAT 17-04, R1, R1'= 220 kΩ, R2 = 470Ω, RL = 100Ω. Der Empfänger-VCO enthält für D1, D1', R1, R1', R2, C5 dieselben Bauteile wie der Sender-VCO. Zusätzlich ist hier der Kondensator C4 = 2,2 pF vorgesehen. Darüber hinaus betragen C1 = 10 pF + einstellbar 3 - 8 pF, C2 = 47 pF, C3 = 4,7 pF, RL = 3,3 kΩ.

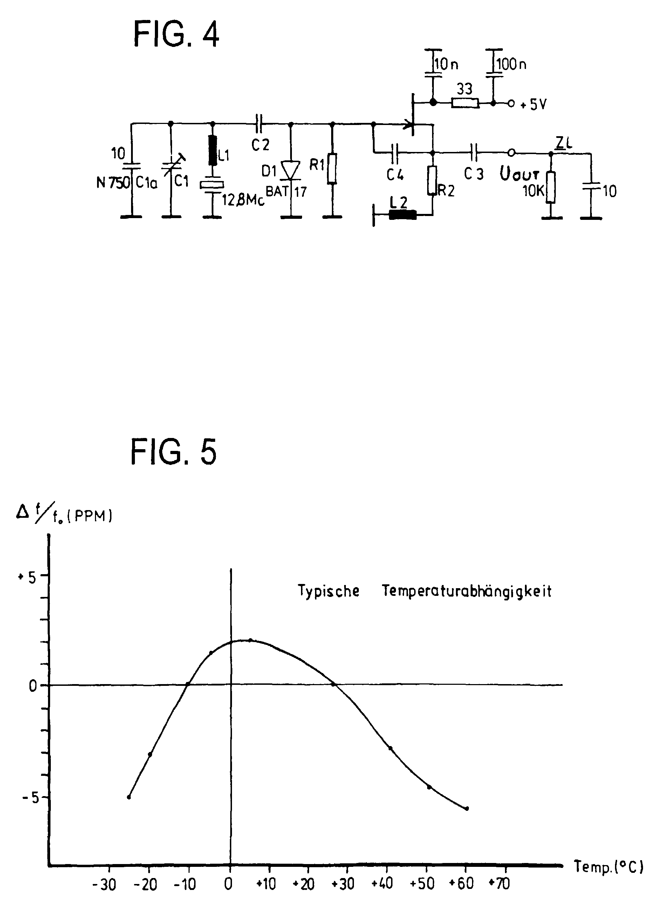

Fig. 4 zeigt einen temperaturkompensierten Quarzoszillator (TCXO). Im Schwingkreis ist ein Quarz vom Typ KVG nach PV Q 098 angeordnet mit einer Serienresonanzfrequenz von 12,8 MHz ± 10 PPM und einer Temperaturdrift ± 7,5 PPM. Zum Zweck der Temperaturkompensation ist parallel zum Quarz der Kondensator C1a = 10 pF geschaltet. C1 ist einstellbar von 3 - 8 pF. Die anderen Bauteile haben eine Dimensionierung von L1 = 6,8 µH, L2 = 100 µH, C2 = 82 pF, C3 = 15 pF, C4 = 8,2 pF, D1- Typ BAT 17, R1 =470 kΩ, R2 = 2,7 kΩ.

Der Oszillator hat eine Stromaufnahme von 0,22 bis 0,37 mA, die Ausgangsspannung an 10 kΩ ∥ 10 pF beträgt 0,6 - 0,9 V_{eff}. Die Temperaturdrift beläuft sich im Bereich von -25 °C bis +60 °C auf ± 8 PPM maximal. Der Oberwellenabstand ist größer als 20 dB. Das Phasenrauschen liegt unterhalb der Nachweisgrenze üblicher Meßeinrichtungen. Die typische Temperaturabhängigkeit des TCXO zeigt Fig. 5.

## Patentansprüche

1. Rauscharmer Oszillator mit einem aus einem einstellbaren Kondensator (C1) und einer Induktivität (L1) bestehenden Schwingkreis der über einen Kondensator (C2) mit dem Eingang (Gate) eines in Drain-Schaltung arbeitenden Sperrschicht-Feldeffekttransistors (JFET) großer Steilheit verbunden ist, dadurch gekennzeichnet, daß eine aus einer Schottky-Diode (D1) sowie mindestens einem parallel zur Schottky-Diode (D1) geschalteten Widerstand (R1) bestehende Diodenklemmschaltung mit dem Eingang (Gate) des in Drain-Schaltung arbeitenden Sperrschicht-Feldeffekttransistors (JFET) verbunden ist, daß an der Drain-Elektrode des Sperrschicht-Feldeffekttransistors (JFET) eine positive Betriebsspannung liegt und eine HF-Abblock-Kapazität (C5) zur negativen Betriebsspannung geschaltet ist und daß die Source des Sperrschicht-Feldeffekttransistors (JFET) über einen Widerstand (R2) und eine Drossel (L2) sowie einem parallel dazu liegenden Kondensator (C3) und einem Widerstand (RL) mit der negativen Betriebsspannung verbunden ist.

2. Rauscharmer Oszillator nach Anspruch 1, dadurch gekennzeichnet, daß zwischen Source und Gate des Sperrschicht-Feldeffekttransistors (JFET) ein Kondensator (C4) geschaltet ist.

3. Rauscharmer Oszillator nach Anspruch 1, dadurch gekennzeichnet, daß die Schottky-Diode (D1) aufgeteilt ist in zwei Schottky-Dioden (D1 und D1') und daß der dazugehörige parallele Widerstand (R1) aufgeteilt ist in zwei den jeweiligen Schottky-Dioden (D1, D1') parallelen Widerständen (R1, R1').

## Claims

1. Low-noise oscillator having a resonant circuit, which comprises a variable capacitor (C1) and an inductor (L1) and is connected via a capacitor (C2) to the input (gate) of a common-drain junction field-effect transistor (JFET) having high transconductance, characterized in that a diode clamping circuit comprising a Schottky diode (D1) as well as at least one resistor (R1) connected in parallel with the Schottky diode (D1) is connected to the input (gate) of the common-drain junction field-effect transistor (JFET), in that a positive operating voltage is connected to the drain electrode of the junction field-effect transistor (JFET) and an RF-blocking capacitor (C5) is connected to the negative operating voltage, and in that the source of the junction field-effect transistor (JFET) is -connected to the negative operating voltage via a resistor (R2) and an inductor (L2) as well as a capacitor (C3) connected in parallel therewith, and a resistor (RL).

2. Low-noise oscillator according to Claim 1, characterized in that a capacitor (C4) is connected between the source and gate of the junction field-effect transistor (JFET).

3. Low-noise oscillator according to Claim 1, characterized in that the Schottky diode (D1) is divided into two Schottky diodes (D1 and D1'), and in that the associated parallel resistor (R1) is divided into two resistors (R1, R1') in parallel with the respective Schottky diodes (D1, D1').

## Revendications

1. Oscillateur à faible bruit comprenant un condensateur réglable (C1) et une inductance (L1) formant un circuit oscillant relié par un condensateur (C2) à l'entrée (grille) d'un transistor à effet de champ à couche de blocage (JFET) fonctionnant en drain, avec une pente importante,
caractérisé en ce qu'
• un circuit de verrouillage de diode composé d'une diode schottky (D1) et d'au moins une résistance (R1) en parallèle à la diode Schottky (D1) est relié à l'entrée (grille) du transistor à effet de champ à couche de blocage (JFET) à montage en drain,
• le drain de ce transistor à effet de champ à couche de blocage (JFET) reçoit une tension de fonctionnement positive,
• une capacité de blocage (HF) (C5) est reliée à la tension de fonctionnement négative, et
• la source du transistor (JFET) est reliée à la tension négative par une résistance (R2) et une bobine (L2) ainsi qu'un condensateur (C3) en parallèle et une résistance (RL).

2. Oscillateur à faible bruit selon la revendication 1,
caractérisé par
un condensateur (C4) branché entre la source et la grille du transistor (JET).

3. Oscillateur à faible bruit selon la revendication 1,
caractérisé en ce que
la diode Schottky (D1) est répartie en deux diodes Schottky (D1 et D1') et la résistance en parallèle (R1) correspondante est répartie en deux résistances (R1, R1') en parallèle sur les diodes Shottky (D1, D1').
